# EUROPEAN PATENT APPLICATION

(11) **EP 3 926 709 A2**
(43) Date of publication of application: **22.12.2021**
(21) Application number: 21180286.3
(22) Date of filing: 18.06.2021
(51) Int. Cl.: H01M 4/04, H01M 4/133, H01M 4/134, H01M 4/1393, H01M 4/1395, H01M 4/38, H01M 4/583, H01M 10/052, H01M 4/02

(54) **NEGATIVE ACTIVE MATERIAL FOR RECHARGEABLE LITHIUM BATTERY, METHOD OF PREPARING SAME, AND RECHARGEABLE LITHIUM BATTERY INCLUDING THE SAME**

(30) Priority: 18.06.2020 KR 20200074396
(71) Applicant: Samsung SDI Co., Ltd., Yongin-si, Gyeonggi-do 17084 (KR)
(72) Inventor: LEE, Jungho, 17084 Yongin-si (KR); NAH, Jaehou, 17084 Yongin-si (KR); SOH, Hyun, 17084 Yongin-si (KR); SON, Inhyuk, 17084 Yongin-si (KR); YOON, Duk-Hyoung, 17084 Yongin-si (KR)
(74) Representative: Shearman, James Ward

(57) **Abstract**

Disclosed are a negative active material for a rechargeable lithium battery, a method of preparing the same and a rechargeable lithium battery including the same, and the negative active material for a rechargeable lithium battery includes an amorphous carbon matrix, silicon particles dispersed in the amorphous carbon matrix, and a nitrogen-containing carbon compound disposed in a form protruding outward on the surface of the amorphous carbon matrix.

## Description

### BACKGROUND OF THE INVENTION

### (a) Field of the Invention

A negative active material for a rechargeable lithium battery, a method of preparing the same, and a rechargeable lithium battery including the same are disclosed.

### (b) Description of the Related Art

Technology development for realizing high capacity of a rechargeable lithium battery has been continuously made due to an increasing demand on a mobile equipment or a portable battery.

As for a positive active material of a rechargeable lithium battery, a lithium-transition metal oxide having a structure capable of intercalating lithium ions such as LiCoO₂, LiMn₂O₄, LiNi₁₋ₓCoₓO₂ (0 < x < 1), and the like has been used.

As for a negative active material, various carbon-based materials including artificial graphite, natural graphite, and hard carbon capable of intercalating and deintercalating lithium ions or Si-based active materials including Si and Sn have been used.

### SUMMARY OF THE INVENTION

An embodiment provides a negative active material for a rechargeable lithium battery having excellent charge and discharge characteristics and excellent cycle-life characteristics.

Another embodiment provides a method of preparing the negative active material.

Another embodiment provides a rechargeable lithium battery including the negative active material.

According to an embodiment, a negative active material for a rechargeable lithium battery includes an amorphous carbon matrix; silicon particles dispersed in the amorphous carbon matrix; and a nitrogen-containing carbon compound disposed in a form protruding outward on the surface of the amorphous carbon matrix.

The nitrogen-containing carbon compound may be disposed in an urchins-type on the surface of the amorphous carbon matrix.

The nitrogen-containing carbon compound may be semi-crystalline.

The nitrogen-containing carbon compound may include piperideine (C₅H₉N), piperidine (C₅H₁₁N), pyridine (C₅H₅N), pyrrole (C₄H₅N), aniline (C6H5NH2), acetonitrile (C₂H₃N), dopamine (C₈H₁₁NO₂), dimethylamine, trimethylamine, ethylamine, diethylamine, trimethylamine, or a combination thereof.

A weight ratio of the amorphous carbon matrix and the nitrogen-containing carbon compound may be about 1:1 to about 1:2.

An amount of the silicon particles may be about 40 wt% to about 80 wt% based on the total weight of the negative active material.

A particle diameter of the silicon particles may be about 40 nm to about 250 nm.

According to another embodiment, a method of preparing a negative active material for a rechargeable lithium battery includes injecting a first carbon gas into the silicon particles and performing heat treatment to prepare an amorphous carbon matrix in which the silicon particles are dispersed; and performing a deposition process using a second carbon gas and a gas of a nitrogen-containing compound on the amorphous carbon matrix, to form a nitrogen-containing carbon compound disposed to protrude to the outside on the surface of the amorphous carbon matrix.

The injecting of the first carbon gas may be performed at a temperature of about 600 °C to about 800 °C.

The deposition process may be a chemical vapor deposition (CVD) process. The deposition process may be performed at a temperature of greater than or equal to about 1000 °C.

The first carbon gas may have a lower decomposition temperature than the second carbon gas.

According to an embodiment, the first carbon gas may be an ethylene (C₂H₄) gas, an acetylene (C₂H₂) gas, a propane (C₃H₈) gas, a propylene (C₃H₆) gas, or a combination thereof, and the second carbon gas may be a methane (CH4) gas.

The nitrogen-containing compound may be ammonia (NH₃), hydrazine (NH2NH2), pyridine (C₅H₅N), pyrrole (C₄H₅N), aniline (C6H5NH2), acetonitrile (C₂H₃N), or a combination thereof.

Another embodiment provides a negative electrode for a rechargeable lithium battery including a current collector and a negative active material layer disposed on the current collector and including the negative active material. The amount of the silicon particles may be about 1 wt% to about 60 wt% based on the total weight of the negative active material.

Another embodiment provides a rechargeable lithium battery including a negative electrode including the negative active material, a positive electrode including a positive active material, and an electrolyte.

The negative active material for a rechargeable lithium battery according to an embodiment may exhibit excellent charge rate and discharge rate characteristics.

At least some of the above and other features of the invention are set out in the claims.

### BRIEF DESCRIPTION OF THE DRAWINGS

FIG. 1 is a schematic view showing a structure of the negative active material for a rechargeable lithium battery according to an embodiment.
FIG. 2 is a schematic view showing the structure of a rechargeable lithium battery according to an embodiment.
FIG. 3A is a 10-fold magnification SEM photograph of the negative active material prepared according to Example 1.
FIG. 3B is a 30-fold magnification SEM photograph of the negative active material prepared according to Example 1.
FIG. 3C is a 50-fold magnification SEM photograph of the negative active material prepared according to Example 1.
FIG. 4 is a graph showing cycle-life characteristics of rechargeable lithium battery cells including negative active materials prepared according to Example 1 and Comparative Examples 1 to 3.

### DETAILED DESCRIPTION OF THE INVENTION

Hereinafter, embodiments of the present invention are described in detail. However, the present invention is not limited to these embodiments and the present invention is defined by the scope of the claims.

A negative active material for a rechargeable lithium battery according to an embodiment includes an amorphous carbon matrix; silicon particles dispersed in the amorphous carbon matrix; and a nitrogen-containing carbon compound disposed in a form protruding outward on the surface of the amorphous carbon matrix.

The nitrogen-containing carbon compound may have an urchins-type. This urchins-type may appear in the form of a needle-shaped or plate-shaped structure protruding outward.

The nitrogen-containing carbon compound may be semi-crystalline.

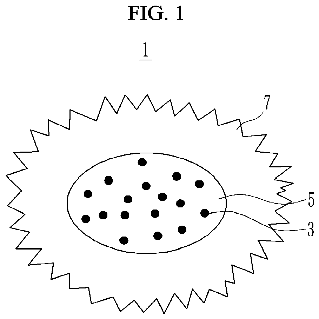

A schematic structure of the negative active material is shown in FIG. 1. As shown in FIG. 1, the negative active material 1 includes an amorphous carbon matrix 5, Si particles 3 dispersed in the amorphous carbon matrix 5, and a nitrogen-containing carbon compound 7 disposed in a form protruding outward on the surface of the amorphous carbon matrix.

As described above, the nitrogen-containing carbon compound may be disposed unevenly in a form protruding outward from the surface of the amorphous carbon matrix 5, that is, in an urchins-type.

This negative active material according to an embodiment includes very high-capacity silicon having a theoretical capacity of about 4200 mAh/g and thus may provide a high-capacity battery, and in addition, when the silicon particles are dispersed in the amorphous carbon matrix, the volume of the silicon particles may be effectively suppressed from being expanded during the charge and discharge and thus cycle-life characteristics may be improved. When the silicon particles are dispersed in a crystalline carbon matrix rather than in the amorphous carbon matrix, the effect of suppressing the volume expansion of silicon may be insignificant, and the reason is that crystalline carbon has higher hardness but lower toughness than amorphous carbon.

In addition, on the surface of the negative active material, semi-crystalline carbon having excellent electrical conductivity is disposed, improving efficiency and charge and discharge rates. Particularly, since the semi-crystalline carbon is the nitrogen-containing carbon compound, the electrical conductivity may be further improved.

When nitrogen is directly added to the amorphous carbon matrix, Si and nitrogen-added amorphous carbon come into direct contact and thus may form silicon nitride (Si₃N₄) and silicon oxynitride (SiOₓN_{y}). In this way, when a compound such as silicon nitride, silicon oxynitride, and the like is present in the amorphous carbon matrix, these compounds are inert materials to lithium, which does not react with lithium, and thus may deteriorate capacity and efficiency.

The amorphous carbon may be soft carbon, hard carbon, or a combination thereof.

The nitrogen-containing carbon compound may be semi-crystalline. In other words, the nitrogen-containing carbon compound has higher crystallinity than amorphous carbon but lower crystallinity than crystalline carbon and thus may be graphite-like crystalline. The carbon compound on the surface of the amorphous carbon matrix is semi-crystalline, that is, carbon having different crystallinity from that of amorphous carbon, wherein carbon in contact with the silicon particles is amorphous carbon and thus may effectively suppress the volume expansion of the silicon particles during charging and discharging, while carbon present on the outside of the active material is semi-crystalline and thus may accomplish an effect of improving electrical conductivity.

The nitrogen-containing carbon compound may include piperideine (C₅H₉N), piperidine (C₅H₁₁N), pyridine (C₅H₅N), pyrrole (C₄H₅N), aniline (C6H5NH2), acetonitrile (C₂H₃N), dopamine (C₈H₁₁NO₂), dimethylamine, trimethylamine, ethylamine, diethylamine, trimethylamine, or a combination thereof.

In an embodiment, the weight ratio of the amorphous carbon matrix and the nitrogen-containing carbon compound may be about 1:1 to about 1:2. When the weight ratio of the amorphous carbon matrix and the nitrogen-containing carbon compound falls within the range, there may be an advantage in expansion characteristics during the cycle-life. When the weight ratio of the amorphous carbon matrix and the nitrogen-containing carbon compound is out of the range, particularly, when the weight of the nitrogen-containing carbon compound is more than twice that of the amorphous carbon matrix, pores inside the amorphous carbon matrix are rapidly formed, and an electrolyte solution may be well penetrated thereinto, which may deteriorate silicon.

In the negative active material, an amount of the silicon particles may be about 40 wt% to about 80 wt% based on the total weight of the negative active material. When the amount of the silicon particles are within the range, excellent discharge capacity and improved capacity retention may be obtained.

In the negative active material, the silicon particles may be present as a silicon cluster formed by agglomeration of a plurality of the silicon particles. When present as the silicon cluster, the silicon cluster may have a size of about 4 µm to about 6 µm. When the silicon cluster has a size within the range, excellent initial expansion may be obtained,

A particle diameter of the silicon particles may be about 40 nm to about 250 nm, and according to an embodiment, about 80 nm to about 120 nm. This particle diameter may mean an average particle diameter. Herein, the average particle diameter is obtained by putting a plurality of particles into a particle size analyzer and measuring it and may be a particle diameter (D50) at a cumulative volume of 50 volume% in a cumulative size-distribution curve. In other words, this particle diameter (D50), unless otherwise defined in the present specification, is an average particle diameter (D50) of particles at a cumulative volume of 50 volume% in the particle size distribution.

The average particle diameter (D50) may be measured using a method well known to those skilled in the art, for example, by using a particle size analyzer or a transmission electron microscope photograph or a scanning electron microscope photograph. In addition, the average particle diameter (D50) may be obtained by measuring a particle size with a device using dynamic light-scattering, performing a data analysis, and counting the number of particles in each particle size range.

The negative active material according to an embodiment may be prepared by the following process.

A first carbon gas is injected into the silicon particles to prepare an amorphous carbon matrix in which the silicon particles are dispersed, and then the amorphous carbon matrix is subjected to a deposition process using a second carbon gas and a gas of a nitrogen-containing compound, to form a nitrogen-containing carbon compound disposed to protrude to the outside on the surface of the amorphous carbon matrix and thus to prepare a negative active material.

The silicon particles may have a particle diameter ranging from about 40 nm to about 250 nm, and according to an embodiment, a particle diameter ranging from about 80 nm to about 120 nm. The silicon particles may be used as a silicon cluster formed by agglomeration of a plurality of the silicon particles. This silicon cluster may be prepared in a spray-drying process.

The first carbon gas has a lower decomposition temperature than the second carbon gas, and herein, when a carbon gas having a low decomposition temperature is used, amorphous carbon may be formed. The first carbon gas may include, for example, ethylene (C₂H₄) gas, acetylene (C₂H₂) gas, propane (C₃H₈) gas, propylene (C₃H₆) gas, or a combination thereof.

The first carbon gas may be injected at about 600 °C to about 800 °C. As the first carbon gas injected according to this injection process is decomposed, the amorphous carbon matrix is formed, and the silicon particles are dispersed in the amorphous carbon matrix. When this first carbon gas injection process is performed within the temperature range, a desired amorphous carbon matrix may be more effectively obtained. When the first carbon gas injection process is performed at a temperature of less than about 600 °C, it does not reach a decomposition temperature of carbon and thus carbon may not be deposited, but when performed at a temperature of greater than about 800 °C, the carbon may be deposited at the same rate but crystallinity of Si may be inappropriately increased.

In addition, the process of forming the amorphous carbon matrix in which the silicon particles are dispersed may be performed by adopting a chemical vapor deposition (CVD) process of injecting the first carbon gas into the silicon particles, a carbonization or electro-spinning process of an organic compound under an inert gas atmosphere, but is not limited thereto.

The second carbon gas may be methane (CH₄) gas. The methane gas may be methane gas with purity of 100% or commercially available methane gas with purity of 99% or higher.

The deposition process using the second carbon gas and the gas of the nitrogen-containing compound may be a chemical vapor deposition (CVD) process. The deposition process may be performed at greater than or equal to about 1000 °C or within a temperature range of about 1000 °C to about 1100 °C.

According to the deposition process, the second carbon gas is decomposed to produce semi-crystalline carbon, while the gas of the nitrogen-containing compound, that is, a gas using the nitrogen-containing compound in a gaseous form is also decomposed to produce nitrogen, and this nitrogen is added into the semi-crystalline carbon, so that a nitrogen-containing carbon compound grows on the surface of the amorphous carbon matrix and thus is placed, for example, in an urchins-type protruding outward from the surface of the amorphous carbon matrix.

When this nitrogen-containing compound is used in a liquid form rather than the gaseous form, the nitrogen-containing carbon compound may be formed as a smooth layered form rather than the protruding form, which may deteriorate capacity, efficiency, rate capability, and cycle-life characteristics.

As described above, since the second carbon gas is used together with the gas of the nitrogen-containing compound during the deposition process, the nitrogen-containing carbon compound may be formed to be protruding outward on the surface of the amorphous carbon matrix through one process without separately performing a process of forming the semi-crystalline carbon and a process of adding the nitrogen.

In the deposition process, the second carbon gas and the gas of the nitrogen-containing compound may be mixed in a volume ratio of about 4 : 3 to about 6 : 1. When the second carbon gas and the gas of the nitrogen-containing compound are mixed within the range, an appropriate nitrogen-containing carbon compound may be prepared.

The nitrogen-containing compound may be ammonia (NH₃), hydrazine (NH2NH2), pyridine (C₅H₅N), pyrrole (C₄H₅N), aniline (C6H5NH2), acetonitrile (C₂H₃N), or a combination thereof.

Another embodiment provides a negative electrode for a rechargeable lithium battery including a current collector and a negative active material layer formed on this current collector and including the negative active material.

In the negative active material layer, the negative active material may be included in an amount of about 95 wt% to about 99 wt% based on the total weight of the negative active material layer.

The negative active material layer may include a binder, and may further optionally include a conductive material. In the negative active material layer, the binder may be included in an amount of about 1 wt% to about 5 wt% based on the total weight of the negative active material layer. In addition, when a conductive material is further included, the negative active material may be used in an amount of about 90 wt% to about 98 wt%, the binder may be used in an amount of about 1 wt% to about 5 wt%, and the conductive material may be used in an amount of about 1 wt% to about 5 wt%.

Herein, the negative active material includes the amorphous carbon matrix, the silicon particles dispersed in the amorphous carbon matrix and the nitrogen-containing carbon compound disposed in a form protruding outward on the surface of the amorphous carbon matrix, and herein, the silicon particles may be included in an amount of about 1 wt% to about 60 wt% based on the total weight of the negative active material.

The binder improves binding properties of negative active material particles with one another and with a current collector. The binder includes a non-aqueous binder, an aqueous binder, or a combination thereof.

The non-aqueous binder may include an ethylene-propylene copolymer, polyacrylonitrile, polystyrene, polyvinylchloride, carboxylated polyvinylchloride, polyvinylfluoride, polyurethane, polytetrafluoroethylene, polyvinylidene fluoride, polyethylene, polypropylene, polyamideimide, polyimide, or a combination thereof.

The aqueous binder may include a styrene-butadiene rubber, an acrylated styrene-butadiene rubber (ABR), an acrylonitrile-butadiene rubber, an acrylic rubber, a butyl rubber, a fluorine rubber, an ethylene oxide-containing polymer, polyvinylpyrrolidone, polyepichlorohydrin, polyphosphazene, an ethylene propylenediene copolymer, polyvinylpyridine, chlorosulfonated polyethylene, latex, a polyester resin, an acrylic resin, a phenolic resin, an epoxy resin, polyvinyl alcohol, or a combination thereof.

When the aqueous binder is used as the negative electrode binder, a cellulose-based compound may be further used to provide viscosity as a thickener. The cellulose-based compound includes one or more of carboxylmethyl cellulose, hydroxypropylmethyl cellulose, methyl cellulose, or alkali metal salts thereof. The alkali metal may be Na, K, or Li. Such a thickener may be included in an amount of about 0.1 parts by weight to about 3 parts by weight based on 100 parts by weight of the negative active material.

The conductive material is included to provide electrode conductivity. Any electrically conductive material may be used as a conductive material unless it causes a chemical change. Examples of the conductive material include a carbon-based material such as natural graphite, artificial graphite, carbon black, acetylene black, ketjen black, a carbon fiber, and the like; a metal-based material of a metal powder or a metal fiber including copper, nickel, aluminium, silver, and the like; a conductive polymer such as a polyphenylene derivative; or a mixture thereof.

The current collector may include one selected from a copper foil, a nickel foil, a stainless steel foil, a titanium foil, a nickel foam, a copper foam, a polymer substrate coated with a conductive metal, and a combination thereof.

Another embodiment provides a rechargeable lithium battery including the negative electrode, a positive electrode including a positive active material and an electrolyte. The positive electrode may include a positive current collector and a positive active material layer on the positive current collector. The positive active material may include lithiated intercalation compounds that reversibly intercalate and deintercalate lithium ions. Specifically, the positive active material may include one or more composite oxides of a metal selected from cobalt, manganese, nickel, and a combination thereof, and lithium. More specific examples may be compounds represented by one of the following chemical formulae. LiaA_{1-b}X_{b}D₂ (0.90 ≤ a ≤ 1.8, 0 ≤ b ≤ 0.5); LiₐA_{1-b}X_{b}O_{2-c}D_{c} (0.90 ≤ a ≤ 1.8, 0 ≤ b ≤ 0.5, 0 ≤ c ≤ 0.05); LiₐE_{1-b}X_{b}O_{2-c}D_{c} (0.90 ≤ a ≤ 1.8, 0 ≤ b ≤ 0.5, 0 ≤ c ≤ 0.05); LiₐE_{2-b}X_{b}O_{4-c}D_{c} (0.90 ≤ a ≤ 1.8, 0 ≤ b ≤ 0.5, 0 ≤ c ≤ 0.05); LiₐNi_{1-b-c}Co_{b}X_{c}D_{α} (0.90 ≤ a ≤ 1.8, 0 ≤ b ≤ 0.5, 0 ≤ c ≤ 0.5, 0 < α ≤ 2); LiₐNi_{1-b-c}Co_{b}X_{c}O_{2-α}T_{α} (0.90 ≤ a≤ 1.8, 0 ≤ b ≤ 0.5, 0 ≤ c ≤ 0.5, 0 < α < 2); LiₐNi_{1-b-c}Co_{b}X_{c}O_{2-α}T₂ (0.90 ≤ a ≤ 1.8, 0 ≤ b ≤ 0.5, 0 ≤ c ≤ 0.05, 0 < α < 2); LiₐNi_{1-b-c}Mn_{b}X_{c}D_{α} (0.90 ≤ a ≤ 1.8, 0 ≤ b ≤ 0.5, 0 ≤ c ≤ 0.05, 0 < α ≤ 2); LiₐNi_{1-b-c}Mn_{b}X_{c}O_{2-α}T_{α} (0.90 ≤ a ≤ 1.8, 0 ≤ b ≤ 0.5, 0 ≤ c ≤ 0.5, 0 < α < 2); LiₐNi_{1-b-c}Mn_{b}X_{c}O_{2-α}T₂ (0.90 ≤ a ≤ 1.8, 0 ≤ b ≤ 0.5, 0 ≤ c ≤ 0.5, 0 < α < 2); LiₐNi_{b}E_{c}G_{d}O₂ (0.90 ≤ a ≤ 1.8, 0 ≤ b ≤ 0.9, 0 ≤ c ≤ 0.5, 0.001 ≤ d ≤ 0.1); LiₐNi_{b}Co_{c}Mn_{d}GₑO₂ (0.90 ≤ a ≤ 1.8, 0 ≤ b ≤ 0.9, 0 ≤ c ≤ 0.5, 0 ≤ d ≤ 0.5, 0.001 ≤ e ≤ 0.1); LiₐNiG_{b}O₂ (0.90 ≤ a ≤ 1.8, 0.001 ≤ b ≤ 0.1) LiₐCoG_{b}O₂ (0.90 ≤ a ≤ 1.8, 0.001 ≤ b ≤ 0.1); LiₐMn_{1-b}GbO₂ (0.90 ≤ a ≤ 1.8, 0.001 ≤ b ≤ 0.1); LiₐMn₂G_{b}O₄ (0.90 ≤ a ≤ 1.8, 0.001 ≤ b ≤ 0.1); LiₐMn_{1-g}G_{g}PO₄ (0.90 ≤ a ≤ 1.8, 0 ≤ g ≤ 0.5); QO₂; QS₂; LiQS₂; V₂O₅; LiV₂O₅; LiZO₂; LiNiVO₄; Li_{(3-f)}J₂(PO₄)₃ (0 ≤ f ≤ 2); Li_{(3-f)}Fe₂(PO₄)₃ (0 ≤ f ≤ 2); LiₐFePO₄ (0.90 ≤ a ≤ 1.8)

In the chemical formulae, A is selected from Ni, Co, Mn, and a combination thereof; X is selected from Al, Ni, Co, Mn, Cr, Fe, Mg, Sr, V, a rare earth element, and a combination thereof; D is selected from O, F, S, P, and a combination thereof; E is selected from Co, Mn, and a combination thereof; T is selected from F, S, P, and a combination thereof; G is selected from Al, Cr, Mn, Fe, Mg, La, Ce, Sr, V, and a combination thereof; Q is selected from Ti, Mo, Mn, and a combination thereof; Z is selected from Cr, V, Fe, Sc, Y, and a combination thereof; and J is selected from V, Cr, Mn, Co, Ni, Cu, and a combination thereof.

The compounds may have a coating layer on the surface, or may be mixed with another compound having a coating layer. The coating layer may include at least one coating element compound selected from an oxide of a coating element, a hydroxide of a coating element, an oxyhydroxide of a coating element, an oxycarbonate of a coating element, and a hydroxyl carbonate of a coating element. The compound for the coating layer may be amorphous or crystalline. The coating element included in the coating layer may include Mg, Al, Co, K, Na, Ca, Si, Ti, V, Sn, Ge, Ga, B, As, Zr, or a mixture thereof. The coating layer may be disposed in a method having no adverse influence on properties of a positive active material by using these elements in the compound. For example, the method may include any coating method such as spray coating, dipping, and the like, but is not illustrated in more detail since it is well-known in the related field.

In the positive electrode, a content of the positive active material may be about 90 wt% to about 98 wt% based on the total weight of the positive active material layer.

In an embodiment, the positive active material layer may further include a binder and a conductive material. Herein, each amount of the binder and the conductive material may be about 1 wt% to about 5 wt% based on the total weight of the positive active material layer.

The binder improves binding properties of positive active material particles with one another and with a current collector. Examples of the binder may include polyvinyl alcohol, carboxylmethyl cellulose, hydroxypropyl cellulose, diacetyl cellulose, polyvinylchloride, carboxylated polyvinylchloride, polyvinylfluoride, an ethylene oxide-containing polymer, polyvinylpyrrolidone, polyurethane, polytetrafluoroethylene, polyvinylidene fluoride, polyethylene, polypropylene, styrene-butadiene rubber, acrylated styrene-butadiene rubber, an epoxy resin, nylon, and the like, but are not limited thereto.

The conductive material is included to provide electrode conductivity. Any electrically conductive material may be used as a conductive material unless it causes a chemical change. Examples of the conductive material may include a carbon-based material such as natural graphite, artificial graphite, carbon black, acetylene black, ketjen black, a carbon fiber and the like; a metal-based material of a metal powder or a metal fiber including copper, nickel, aluminium, silver, and the like; a conductive polymer such as a polyphenylene derivative; or a mixture thereof.

The current collector may include Al, but is not limited thereto.

The electrolyte includes a non-aqueous organic solvent and a lithium salt.

The non-aqueous organic solvent serves as a medium for transmitting ions taking part in the electrochemical reaction of a battery.

The non-aqueous organic solvent may include a carbonate-based, ester-based, ether-based, ketone-based, alcohol-based, or aprotic solvent.

The carbonate based solvent may include dimethyl carbonate (DMC), diethyl carbonate (DEC), dipropyl carbonate (DPC), methylpropyl carbonate (MPC), ethylpropyl carbonate (EPC), methylethyl carbonate (MEC), ethylene carbonate (EC), propylene carbonate (PC), butylene carbonate (BC), and the like. The ester-based solvent may include methyl acetate, ethyl acetate, n-propyl acetate, t-butyl acetate, dimethylacetate, methylpropionate, ethylpropionate, decanolide, mevalonolactone, caprolactone, and the like. The ether-based solvent may include dibutyl ether, tetraglyme, diglyme, dimethoxyethane, 2-methyltetrahydrofuran, tetrahydrofuran, and the like. The ketone-based solvent includes cyclohexanone and the like. The alcohol-based solvent includes ethyl alcohol, isopropyl alcohol, and the like, and examples of the aprotic solvent include nitriles such as R-CN (where R is a C2 to C20 linear, branched, or cyclic hydrocarbon, a double bond-included aromatic ring, or an ether bond), amides such as dimethylformamide, dioxolanes such as 1,3-dioxolane, sulfolanes, and the like.

The organic solvent may be used alone or in a mixture. When the organic solvent is used in a mixture, the mixture ratio may be controlled in accordance with a desirable battery performance.

In addition, in the case of the carbonate-based solvent, it is desirable to use a mixture of cyclic carbonate and chain carbonate. In this case, when the cyclic carbonate and the chain carbonate are mixed in a volume ratio of about 1:1 to about 1:9, the electrolyte may exhibit excellent performance.

The organic solvent may further include an aromatic hydrocarbon-based organic solvent in addition to the carbonate-based solvent. Herein, the carbonate-based solvent and the aromatic hydrocarbon-based organic solvent may be mixed in a volume ratio of about 1:1 to about 30:1.

The aromatic hydrocarbon-based organic solvent may be an aromatic hydrocarbon-based compound of Chemical Formula 1.

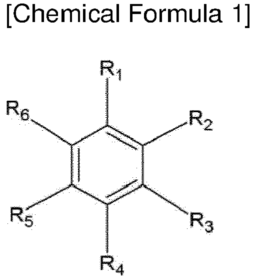

In Chemical Formula 1, R₁ to R₆ are the same or different and are selected from hydrogen, a halogen, a C1 to C10 alkyl group, a haloalkyl group, and a combination thereof.

Specific examples of the aromatic hydrocarbon-based organic solvent may be selected from benzene, fluorobenzene, 1,2-difluorobenzene, 1,3-difluorobenzene, 1,4-difluorobenzene, 1,2,3-trifluorobenzene, 1,2,4-trifluorobenzene, chlorobenzene, 1,2-dichlorobenzene, 1,3-dichlorobenzene, 1,4-dichlorobenzene, 1,2,3-trichlorobenzene, 1,2,4-trichlorobenzene, iodobenzene, 1,2-diiodobenzene, 1,3-diiodobenzene, 1,4-diiodobenzene, 1,2,3-triiodobenzene, 1,2,4-triiodobenzene, toluene, fluorotoluene, 2,3-difluorotoluene, 2,4-difluorotoluene, 2,5-difluorotoluene, 2,3,4-trifluorotoluene, 2,3,5-trifluorotoluene, chlorotoluene, 2,3-dichlorotoluene, 2,4-dichlorotoluene, 2,5-dichlorotoluene, 2,3,4-trichlorotoluene, 2,3,5-trichlorotoluene, iodotoluene, 2,3-diiodotoluene, 2,4-diiodotoluene, 2,5-diiodotoluene, 2,3,4-triiodotoluene, 2,3,5-triiodotoluene, xylene, and a combination thereof.

The electrolyte may further include an additive of vinylene carbonate or an ethylene carbonate-based compound of Chemical Formula 2 in order to improve a cycle-life of a battery.

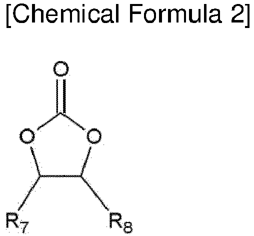

In Chemical Formula 2, R₇ and R₈ are the same or different and selected from hydrogen, a halogen, a cyano group (CN), a nitro group (NO₂), and a fluorinated C1 to C5 alkyl group, provided that at least one of R₇ and R₈ is selected from a halogen, a cyano group (CN), a nitro group (NO₂), and a fluorinated C1 to C5 alkyl group, and R₇ and R₈ are not simultaneously hydrogen.

Examples of the ethylene carbonate-based compound may be difluoro ethylene carbonate, chloroethylene carbonate, dichloroethylene carbonate, bromoethylene carbonate, dibromoethylene carbonate, nitroethylene carbonate, cyanoethylene carbonate, or fluoroethylene carbonate. The amount of the additive for improving a cycle-life may be used within an appropriate range.

The lithium salt dissolved in an organic solvent supplies a battery with lithium ions, basically operates the rechargeable lithium battery, and improves transportation of the lithium ions between positive and negative electrodes. Examples of the lithium salt include at least one supporting salt selected from LiPF₆, LiBF4, LiSbF₆, LiAsF₆, LiN(SO₂C₂F₅)₂, Li(CF₃SO₂)₂N, LiN(SO₃C₂F₅)₂, Li(FSO₂)₂N (lithium bis(fluorosulfonyl)imide: LiFSI), LiC₄F₉SO₃, LiClO₄, LiAlO₂, LiAlCl₄, LiN(CₓF₂ₓ₊₁SO₂)(C_{y}F_{2y+1}SO₂), wherein, x and y are natural numbers, for example an integer of 1 to 20, LiCI, Lil, and LiB(C₂O₄)₂ (lithium bis(oxalato) borate: LiBOB). A concentration of the lithium salt may range from about 0.1 M to about 2.0 M. When the lithium salt is included at the above concentration range, an electrolyte may have excellent performance and lithium ion mobility due to optimal electrolyte conductivity and viscosity.

The rechargeable lithium battery may further include a separator between the negative electrode and the positive electrode, depending on a kind of the battery. Examples of a suitable separator material include polyethylene, polypropylene, polyvinylidene fluoride, and multi-layers thereof such as a polyethylene/polypropylene double-layered separator, a polyethylene/polypropylene/polyethylene triple-layered separator, and a polypropylene/polyethylene/polypropylene triple-layered separator.

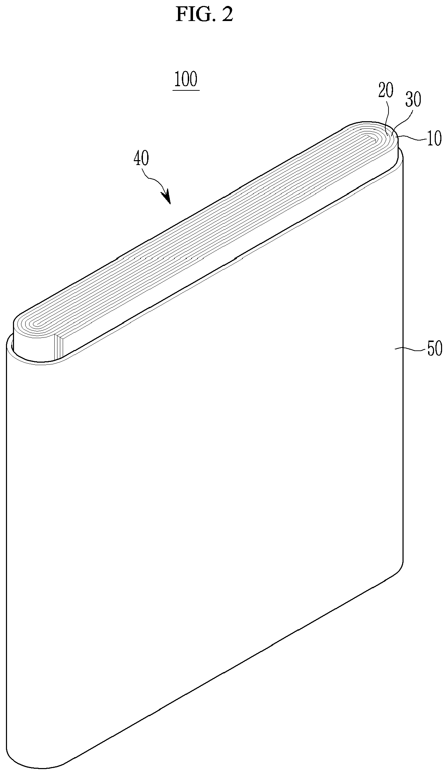

FIG. 2 is an exploded perspective view of a rechargeable lithium battery according to one embodiment. The rechargeable lithium battery according to an embodiment is illustrated as a prismatic battery but is not limited thereto and may include variously-shaped batteries such as a cylindrical battery, a pouch battery, and the like.

Referring to FIG. 2, a rechargeable lithium battery 100 according to an embodiment includes an electrode assembly 40 manufactured by winding a separator 30 interposed between a positive electrode 10 and a negative electrode 20, and a case 50 housing the electrode assembly 40. An electrolyte (not shown) may be impregnated in the positive electrode 10, the negative electrode 20, and the separator 30.

Hereinafter, examples of the present invention and comparative examples are described. These examples, however, are not in any sense to be interpreted as limiting the scope of the invention.

### (Example 1)

Silicon particles were pulverized to prepare silicon particles having an average particle diameter (D50) of 100 nm.

The obtained silicon particles having an average particle diameter (D50) of 100 nm were spray-dried to prepare silicon clusters having an average particle diameter (D50) of 5 µm.

Subsequently, ethylene (C₂H₂) gas was injected into the silicon clusters to perform a chemical vapor deposition (CVD) at 800 °C. Through this process, an amorphous carbon matrix was formed, and the silicon clusters were dispersely disposed in the amorphous carbon matrix.

Subsequently, while methane (CH₄) gas and NH₃ gas in a volume ratio of 4 : 3 were injected into the amorphous carbon matrix, the chemical vapor deposition (CVD) was performed at 1000 °C. Through this process, on the surface of the amorphous carbon matrix, a piperideine compound that is a semi-crystalline nitrogen-containing carbon compound was grown, preparing a negative active material for a rechargeable lithium battery including the nitrogen-containing carbon compound in an urchins-type protruding outward on the surface of the amorphous carbon matrix.

In the prepared negative active material, an amount of the silicon particles was 55 wt% based on the total weight of the negative active material, an amount of the amorphous carbon was 20 wt% based on the total weight of the negative active material, and an amount of the semi-crystalline nitrogen containing-carbon compound was 25 wt% based on the total weight of the negative active material.

97.5 wt% of the negative active material, 1.0 wt% of carboxylmethyl cellulose, and 1.5 wt% of styrene-butadiene rubber were mixed in distilled water to prepare a negative active material slurry composition.

The negative active material slurry composition was coated on a Cu current collector and then, dried and compressed to manufacture a negative electrode for a rechargeable lithium battery.

The negative electrode, a lithium metal counter electrode, and an electrolyte solution were used to fabricate a half-cell. The electrolyte solution was prepared by using a mixed solvent of ethylene carbonate and dimethyl carbonate (a volume ratio of 3:7) and dissolving 1 M LiPF₆ therein.

### (Comparative Example 1)

The silicon clusters according to Example 1 and petroleum pitch were mixed in a weight ratio of 46 : 54, heat-treating the mixture at 950 °C to prepare a negative active material for a rechargeable lithium battery in which the silicon clusters were dispersed in a soft carbon amorphous carbon matrix.

The negative active material was used according to the same method as Example 1 to manufacture a negative electrode and a half-cell.

### (Comparative Example 2)

Silicon particles were pulverized to prepare silicon particles having an average particle diameter (D50) of 100 nm.

The obtained silicon particles having an average particle diameter (D50) of 100 nm were spray-dried to prepare silicon clusters having an average particle diameter (D50) of 5 µm.

Subsequently, ethylene (C₂H₂) gas was injected into the silicon clusters to perform chemical vapor deposition (CVD) at 800 °C. Through this process, an amorphous carbon matrix was formed, and the silicon clusters were disperesly disposed in the amorphous carbon matrix.

Subsequently, while methane (CH₄) gas was injected into the amorphous carbon matrix, the chemical vapor deposition (CVD) was performed at 1000 °C. Through this process, on the surface of the amorphous carbon matrix, semi-crystalline carbon was grown, preparing a negative active material for a rechargeable lithium battery including the semi-crystalline carbon in an urchins-type protruding outward on the surface of the amorphous carbon matrix.

In the prepared negative active material, an amount of the silicon particles was 55 wt% based on the total weight of the negative active material, an amount of the amorphous carbon was 20 wt% based on the total weight of the negative active material, and an amount of the semi-crystalline carbon compound was 25 wt% based on the total weight of the negative active material.

The negative active material was used according to the same method as Example 1 to manufacture a negative electrode and a half-cell.

### (Comparative Example 3)

0.6 g of the silicon clusters according to Example 1 and 1.4 g of an 1-ethyl-3-methylimidazolium dicyanamide ionic liquid were well mixed. The mixture was heat-treated under nitrogen gas at 300 °C for 1 hour and then carbonized at 1000 °C for 1 hour, preparing a negative active material for a rechargeable lithium battery in which nitrogen-doped carbon was coated on SiO₂.

The negative active material was used according to the same method as Example 1 to manufacture a negative electrode and a half-cell.

### * SEM Photograph

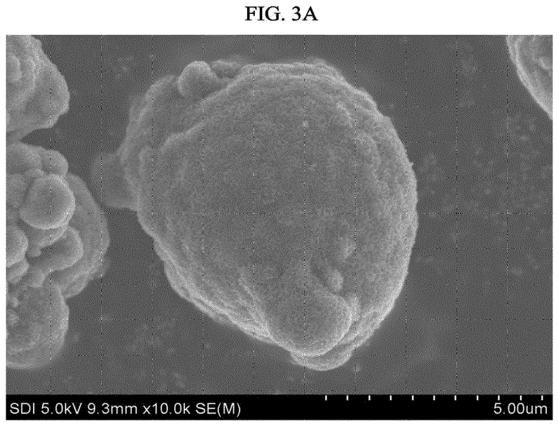

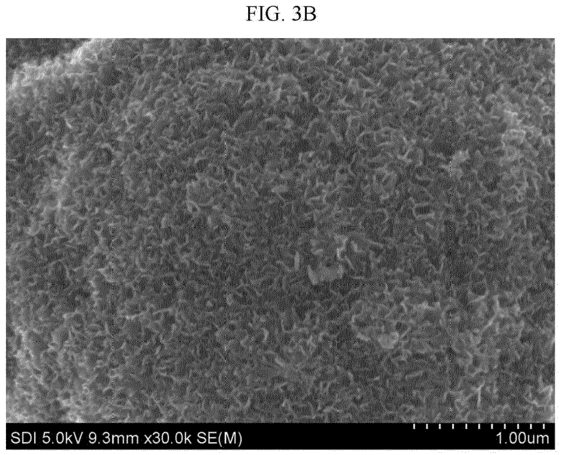

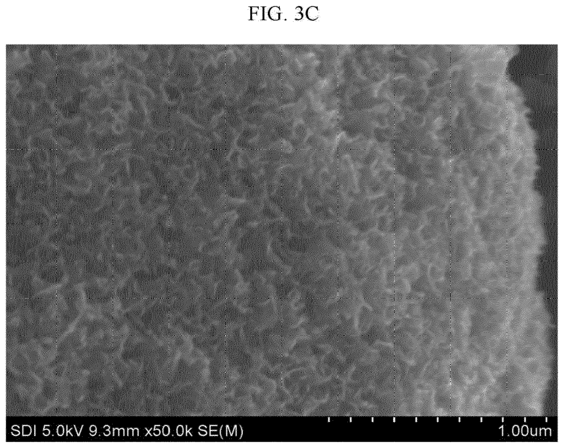

FIG. 3A shows a 10-fold magnification SEM photograph of the negative active material according to Example 1, FIG. 3B shows a 30-fold magnification SEM photograph thereof, and FIG. 3C shows a 50-fold magnification SEM photograph thereof. As shown in FIGS. 3A, 3B, and 3C, the negative active material of Example 1 had an uneven surface in an urchins-type, from which the nitrogen-containing carbon compound clearly existed in the urchins-type protruding outward on the surface.

### * Evaluation of Formation Charge/Discharge Characteristics

The half-cells according to Example 1 and the Comparative Examples 1 to 3 were once charged and discharged at 1 C, measuring charge capacity and discharge capacity. Efficiency (a percentage of discharge capacity/charge capacity) of the cells was calculated as discharge capacity relative to the measured charge capacity, and the results are provided as formation efficiency in Table 1. In addition, the measured discharge capacity was shown as a standard discharge in Table 1. * Evaluation of High-rate Characteristics

The half-cells according to Example 1 and the Comparative Examples 1 to 3 were once charged and discharged at 0.2 C and then, once charged and discharged at 2 C, measuring charge capacity and discharge capacity. A ratio of the measured 2 C charge capacity related to the measured 0.2 C charge capacity was calculated, and the results as a charge rate are shown in Table 1, and a ratio of the measured 2 C discharge capacity related to the measured 0.2 C discharge capacity was calculated, and the results as a discharge rate are shown in Table 1.

**(Table 1)**

| | Example 1 | Comparative Example 1 | Comparative Example 2 | Comparative Example 3 |
|---|---|---|---|---|
| Formation efficiency (%) | 90.1 | 88.5 | 89.8 | 86.2 |
| Standard discharge (mAh/g) | 506.5 | 504.1 | 503.6 | 498.2 |
| Charge rate (2C/0.2C, %) | 42.0 | 41.8 | 40.3 | 34.8 |
| Discharge rate (2C/0.2C, %) | 96.6 | 95.9 | 95.9 | 96.0 |

As shown in Table 1, the half-cell of Example 1 exhibited excellent formation efficiency and standard discharge characteristics, compared with the half-cells of Comparative Examples 1 to 3. In addition, the half-cell of Example 1 exhibited excellent charge rate and discharge rate, compared with the half-cells of Comparative Examples 1 to 3.

### * Evaluation of Cycle-life Characteristics

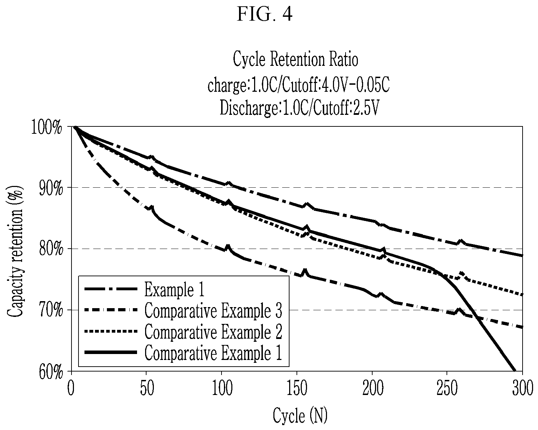

The half-cells of Example 1 and the Comparative Examples 1 to 3 were charged under conditions of 1.0 C and a 4.0 V-0.05 C cut-off and discharged under conditions of 1.0 C and 2.5 V cut-off, which was 300 times repeated. When 1^{st} discharge capacity was regarded as 100%, a capacity ratio at each cycle was calculated, and the results as capacity retention are shown in FIG. 4.

As shown in FIG. 4, Example 1 exhibited excellent capacity retention at the 300^{th} charge and discharge, compared with those of Comparative Examples 1 to 3. Comparative Example 1 including silicon and amorphous carbon alone exhibited sharply decreased capacity retention after the 250^{th} charge and discharge, Comparative Example 2 including semi-crystalline carbon in addition to the silicon and the amorphous carbon exhibited no sharply decreased capacity retention even after the 250^{th} charge and discharge but lower capacity retention than that of Example 1. In addition, Comparative Example 3 to which nitrogen as a liquid was added exhibited the lowest capacity retention.

Referring to these results, even though a carbon layer formed of crystalline carbon was included, when doped with nitrogen, particularly, doped with gaseous nitrogen, the capacity retention turned out to be more improved.

While this invention has been described in connection with what is presently considered to be practical example embodiments, it is to be understood that the invention is not limited to the disclosed embodiments, but, on the contrary, is intended to cover various modifications and equivalent arrangements included within the scope of the appended claims.

## Claims

1. A negative active material for a rechargeable lithium battery, comprising:
an amorphous carbon matrix;
silicon particles dispersed in the amorphous carbon matrix; and
a nitrogen-containing carbon compound disposed in a form protruding outward on the surface of the amorphous carbon matrix.

2. The negative active material of claim 1, wherein the nitrogen-containing carbon compound is disposed in an urchins-type on the surface of the amorphous carbon matrix.

3. The negative active material of claim 1 or claim 2, wherein the nitrogen-containing carbon compound is semi-crystalline.

4. The negative active material of any one of claims 1 to 3, wherein the nitrogen-containing carbon compound comprises piperideine (C₅H₉N), piperidine (C₅H₁₁N), pyridine (C₅H₅N), pyrrole (C₄H₅N), aniline (C6H5NH2), acetonitrile (C₂H₃N), dopamine (C₈H₁₁NO₂), dimethylamine, trimethylamine, ethylamine, diethylamine, trimethylamine, or a combination thereof.

5. The negative active material of any one of claims 1 to 4, wherein a weight ratio of the amorphous carbon matrix and the nitrogen-containing carbon compound is about 1:1 to about 1:2.

6. The negative active material of any one of claims 1 to 5, wherein an amount of the silicon particles is about 40 wt% to about 80 wt% based on the total weight of the negative active material.

7. The negative active material of any one of claims 1 to 6, wherein a particle diameter of the silicon particles is about 40 nm to about 250 nm.

8. A method of preparing a negative active material for a rechargeable lithium battery, comprising
injecting a first carbon gas into the silicon particles and performing heat treatment to prepare an amorphous carbon matrix in which the silicon particles are dispersed;
performing a deposition process using a second carbon gas and gas of a nitrogen-containing compound on the amorphous carbon matrix, to form a nitrogen-containing carbon compound disposed to protrude to the outside on the surface of the amorphous carbon matrix.

9. The method of claim 8, wherein:
(i) the injecting of the first carbon gas is performed at a temperature of about 600 °C to about 800 °C; and/or
(ii) the deposition process is a chemical vapor deposition (CVD) process.

10. The method of claim 8 or claim 9, wherein the deposition process is performed at a temperature of greater than or equal to about 1000 °C.

11. The method of any one of claims 8 to 10, wherein
the first carbon gas has a lower decomposition temperature than the second carbon gas.

12. The method of any one of claims 8 to 11, wherein the first carbon gas is an ethylene (C₂H₄) gas, an acetylene (C₂H₂) gas, a propane (C₃H₈) gas, a propylene (C₃H₆) gas, or a combination thereof.

13. The method of any one of claims 8 to 12, wherein:
(i) the second carbon gas is a methane (CH₄) gas; and/or
(ii) the nitrogen-containing compound is ammonia (NH₃), hydrazine (NH2NH2), pyridine (C₅H₅N), pyrrole (C₄H₅N), aniline (C6H5NH2), acetonitrile (C₂H₃N), or a combination thereof.

14. A negative electrode for a rechargeable lithium battery, comprising
a current collector and
a negative active material layer disposed on the current collector and including the negative active material of any one of claims 1 to 7, optionally wherein the content of the silicon particles is about 1 wt% to about 60 wt% based on the total weight of the negative active material.

15. A rechargeable lithium battery, comprising
a negative electrode including a negative active material of any one of claims 1 to 7;
a positive electrode including a positive active material; and
an electrolyte.
